# EUROPÄISCHE PATENTANMELDUNG

(11) **EP 1 063 327 A2**
(43) Veröffentlichungstag der Anmeldung: **27.12.2000**
(21) Anmeldenummer: 00110862.0
(22) Anmeldetag: 23.05.2000
(51) Int. Cl.: D03D 15/00

(54) **Silbergewebe zur Abschirmung elektrischer und hochfrequenter magnetischer Felder**

(30) Priorität: 25.06.1999 DE 19929077
(71) Anmelder: SAMINA Produktions- und Handels GmbH, 6820 Frastanz (AT)
(72) Erfinder: Amann, Günther, 6820 Frastanz (AT)
(74) Vertreter: Riebling, Peter, Dr.-Ing.

(57) **Zusammenfassung**

Die vorliegende Erfindung beschäftigt sich mit einem Spezialgewebe, welches einen entsprechenden Silberanteil aufweist, um geeignet zu sein, Potentialunterschiede an der Oberfläche und in einem sich über dem Gewebe bis zu einem Abstand von etwa 50 cm erstreckenden Raum einen potentialunterschiedfreien Bereich auszubilden.

## Beschreibung

Die vorliegende Erfindung beschäftigt sich mit dem Problem der möglichst effektiven Abschirmung bestimmter definierter Bereiche gegenüber den Einwirkungen magnetischer und elektrischer Felder sowohl im medizinischen Bereich als auch im Bereich des alltäglichen Lebens.

Es ist bekannt, daß durch den Einsatz von metallisierten Folien eine Ableitung von elektromagnetischen Feldern und statischen Aufladungen über eine Erdung möglich ist. Dazu gab und gibt es die unterschiedlichsten Ausführungen, die vorzugsweise an Schlafplätzen und innerhalb von Liegeflächen Verwendung finden. Besonders nachteilig war dabei, daß diese Folien sehr oft nicht atmungsaktiv waren und auf nicht dauerhaft haltbares Trägermaterial aufgebracht wurden (z.B. Papiervlies). Dies führt innerhalb von Liegeflächen sehr oft bei Bewegungen zu störenden Geräuschen (Rascheleffekt) und das aufkaschierte Trägermaterial löst sich durch mechanische Reibung ab. Besonders durch diese Beschaffenheit und die verwendeten leitfähigen Materialien war es nachteilig, daß diese Folien nicht in unmittelbarer Körpernähe verwendet werden konnten, das heißt, ein direktes Daraufliegen und -schlafen war nicht möglich. Gerade dies wäre aber im Hinblick auf eine optimale Ableitung von elektrischen und elektrostatischen Feldern gegen Erde physikalisch optimal. Bisher werden diese Folien in der Regel unterhalb von Matratzen oder Matratzenschonern verwendet, was die Wirkungsweise massiv verschlechtert, da kein unmittelbarer Körperkontakt möglich ist und damit nur eine ungenügende Ableitung ermöglicht.

Zwischenzeitlich ist auch bekannt, in Stoffgewebe Metallfäden einzuarbeiten, um dadurch eine elektrische Leitfähigkeit und in der Folge eine Abschirmung/Ableitung der statischen und elektrischen Felder zu erreichen. Daher ist eines der Probleme, daß die bisher verwendeten leitfähigen Materialien auch einen unterschiedlich wirkenden elektrischen Widerstand innerhalb der Gesamtfläche aufweisen. Die gleichmässige Ableitung der elektrischen Ströme gegen Erde ist aber aus biologischer Sicht jedoch sehr wichtig, da es ansonsten zu zusätzlichen Verschiebeströmen innerhalb des Körpers kommt bzw. die Ableitung je nach Körperregion und Entfernung zur Erdung unterschiedlich ist. Bei den meisten dieser Ausführungen ist auch nachteilig, daß als leitfähiges Material magnetisierbare Metalle (z.B. Eisen-/Stahlfäden) verwendet werden, welches zu einer Verzerrung des natürlichen Erdmagnetfeldes innerhalb der Liegefläche führt. Nach neuesten wissenschaftlichen Erkenntnissen hat das natürliche Erdmagnetfeld einen biologischen Ordnungsfaktor und sollte ungestört auf den Menschen einwirken können;. insbesondere während der nächtlichen Schlafphase.

Mit dem guten Schlaf ist es wie mit vielen Dingen in unserem Leben. Man nimmt es als selbstverständlich hin. Aber dies ist auch mit dem guten Schlafen nur solange möglich, solange man damit keine Probleme hat. Für Millionen Menschen ist es längst keine Selbstverständlichkeit mehr, nachts gut und tief zu schlafen. Die Ursachen dafür sind viel tiefgreifender und vielschichtiger als man bis heute glaubte. Einig ist man sich aber diesbezüglich in einer Sache: wer nachts über einen längeren Zeitraum schlecht schläft, gefährdet seine Gesundheit. Durch die mangelnde Regeneration gehen zuerst Leistungskraft, Vitalität und geistige Fitneß verloren. Nervosität, Kreislaufschwäche, Wetterfühligkeit, Migräne u.v. a. Beschwerden können die Folge sein. Zu einem gesunden leben während dem Tag gehört auch ein gesunder Schlaf während der nächtlichen Regenerationsphase. Das Ergebnis ist ein tiefer, bio-regenerativer Schlaf in der Nacht.

50% der Menschen in der 'zivilisierten Welt' leidet an mehr oder weniger chronischen Schlafstörungen. Die Ursachen sind sehr vielschichtig. Durch die Technisierung und Elektrifizierung der Arbeits-, Wohn- und vor allem Schlafumwelt des Menschen, haben diese Störungen massiv zugenommen. Namhafte Wissenschaftler sind überzeugt, daß einer der häufigsten Ursache für Schlafstörungen technisch physikalische Felder an Schlafplätzen sind.

Zwischen 80% und 90% aller Schlafplätze sind elektrobiologisch durch physikalisch bedingte Felder und Wellen gestört. Im Vordergrund stehen die elektrischen Wechselfelder des Hausstromnetzes (220 Volt/50 Hertz). So entsteht unter anderem auf der Hautoberfläche eine Wechselspannung mit 50 Hertz-Frequenzen, welche die körpereigenen elektrischen und magnetischen Felder überlagern bzw. stören. Dies ist durch Messungen nachweisbar. Die Folge sind sehr oft Schlafstörungen, Nervosität, Unruhezustände, Kreislaufbeschwerden usw.

Feinste elektrische Spannungen und magnetische Ströme pulsieren innerhalb jeder unserer Zellen - Tag und Nacht. Diese Körperelektrizität hält uns am Leben. Leben bedeutet Elektrizität. Über viele Jahrtausende hinweg vollzog sich dieser elektrische Vorgang in unserem Körper in Harmonie mit der Natur. Gerade die elektrischen und magnetischen Schwingungen der Natur (z.B. die natürliche Luftelektrizität und das natürliche Erdmagnetfeld) wirkten im Freien und in den Behausungen ununterbrochen auf den Menschen ein. Dazu auch die biologisch wichtige 10 Hertz-Schumann-Resonanz. Heute schirmen die Bauweise der Gebäude und die Zivilisation diese wichtigen natürlichen Schwingungen und Felder weitgehend von uns ab. Die technischen Felder haben hingegen in den letzten Jahrzehnten massiv in unsere Lebensumwelt Einzug gehalten. Dies kann den biologisch so wichtigen Schlaf massiv gefährden.

Unser Körper steht als Teil der Natur im Wechselspiel eines für seine Leistungsfähigkeit und Energie wesentlichen, natürlichen elektrischen Spannungsfeldes. Elektrotechnische Einrichtungen in unseren Wohn- und Arbeitsräumen, die Verwendung synthetischer Materialien und Stoffe, haben eine extreme Behinderung für unseren Körper mit sich gebracht. Der wichtige Dialog von Körper und Natur ist gestört. Die Wechselwirkungen zwischen Umwelt und Mensch sind zunehmend negativ geworden.
Wir wissen vom Radio her, daß der Mensch ein sehr guter Empfänger ist. Wenn man mit dem Finger die Antennenbuchse des Radios berührt, wird der Empfang viel besser. Der Mensch ist daher eine ausgezeichnete Antenne für Radiowellen. Er ist aber auch ein guter Empfänger für alle natürlichen und technischen Wellen und Felder. Die kapazitiven Aufladungen von z.B. elektrischen Wechselfeldern ist mit Meßgeräten sehr leicht nachweisbar. Die Frequenzen können entsprechende Auswirkungen auf den Organismus haben. Gerade während der Nachtruhe können diese Einflüsse Schlaf und Regeneration nachhaltig stören.

Die elektrischen und magnetischen Wechselfelder, wie sie von jeder Elektroinstallation und den daran angeschlossenen Geräten und Verbrauchern ausgehen, erzeugen auch in unserem Körper zusätzliche Spannungen und Ströme. Diese sind in den meisten Fällen wesentlich stärker, als die elektrischen Vorgänge in unserem Körper.

Der gesunde Körper kann zwar, wie man aus der Praxis weiß, mit diesen Belastungen durchaus fertig werden. Aber nicht ohne Anstrengung und Streß. Dies führt gerade während dem Schlaf zu einer oft massiven Beeinträchtigung der Schlafqualität und der Regeneration. Insgesamt hat durch die Dauerbeeinflussung die Anzahl der elektrosensiblen Menschen stark zugenommen.

Diese Belastungen wirken erst seit einigen Jahrzehnten auf uns ein. Und die typischen Zivilisationskrankheiten, wie Herz-Kreislaufkrankheiten, Migräne, Bluthochdruck, Rheuma und degenerative Erkrankungen, wie z.B. Krebs, gehen mit unserem technischen Fortschritt einher.

Längst hat die Wissenschaft begonnen, die Zivilisationskrankheiten und deren Ursachen systematisch zu erforschen. Die Ergebnisse zeigen uns deutlich, daß nicht nur chemische Verschmutzung von Luft, Nahrungsmitteln und Wasser an der Entstehung beteiligt sind. Neueste wissenschaftliche Forschungsergebnisse weisen immer deutlicher darauf hin, daß der zunehmend Elektrosmog an der Entstehung vieler Beschwerden und Krankheiten mitbeteiligt ist.

Elektromagnetische Strahlungsfelder unterschiedlichster Herkunft und Frequenzen haben sich in den letzten Jahren stark ausgebreitet und sind zu einer Belastung von Umwelt und Gesundheit geworden. Diese Störstrahlung durchdringt ungehindert Wände, Decken, Fußböden und erreicht als 'Elektrosmog' unsere Wohn-, Arbeits- und insbesondere Schlafräume. Unzählige Wissenschaftler beschäftigten sich seit einigen Jahrzehnten mit den gesundheitlichen Auswirkungen dieser Felder auf den Menschen. Die Ergebnisse zeigen immer deutlicher, daß die gesetzlich festgelegten Grenzwerte längst nicht mehr ausreichend sind. Damit sind insbesondere elektrosensible Personen ernstzunehmenden, gesundheitlichen Risiken ausgesetzt. Einer der führenden Wissenschaftler auf dem Gebiet der Elektrobioklimatologie ist Prof. Dipl.Ing. Dr. András Varga vom Hygiene-Institut der Universität Heidelberg. Er erforscht seit Jahrzehnten die Einflüsse natürlicher und durch den Menschen erzeugter elektromagnetischer Strahlung auf Mensch, Tier und Pflanze. In diesem Zusammenhang veröffentlichte er ein Buch 'Pyhsikalische Umwelt und Gesundheit der Menschen'. In diesem Buch werden die unzähligen gesundheitlichen Gefahren unserer Umwelt, insbesondere der technischen Strahlen, sehr ausführlich und wissenschaftlich fundiert beschrieben.

Nur wer im Schlaf wirklich Kraft für den neuen Tag gewinnen kann, kann in unserer Leistungsgesellschaft wirklich bestehen. Der gesunde, bio-regenerative Schlaf wird für den gestreßten Zivilisationsmenschen immer wichtiger; beruflich, privat und vor allem gesundheitlich. Die Schlafqualität ist von vielen Faktoren abhängig: von der richtigen Schlafunterlage bis hin zum Raumklima. Längst haben Wissenschaftler bestätigt, daß die künstlich erzeugen Felder vom Menschen während dem Tag und Wachbewußtsein viel besser verkraftet werden. Der nächtliche 'Elektrostreß' hingegen läßt die biologischen Systeme des Körpers nicht zum dringend notwendigen Ausgleich finden. Die Schlafqualität wird zunehmend beeinträchtigt und eine optimale Regeneration von Körper, Seele und Geist ist nur noch ungenügend möglich. Schlafstörungen, Kreislaufprobleme, Nervosität und Leistungsabfall sind oft die ersten Signale.

In elektrifizierten Häusern und Wohnungen sind an Schlafplätzen immer Belastungen meßbar. Diese entstehen in erster Linie aus der haus- oder wohnungseigenen Elektroinstallation und den daran angeschlossenen Geräten. Zunehmend kommen aber auch Strahlungsquellen von außen in Frage. Im niederfrequenten Bereich sind dies z. B. Hochspannungs-Freileitungen, Bahnlinien, Trafostationen. Aber auch die hochfrequenten Strahlungsformen (Mikrowellen) nehmen mit der Technisierung massiv zu. Dazu zählen alle Sendeeinrichtungen von Funk, Fernsehen, Telefon (Handy) etc. Gerade während der nächtlichen Regeneration wirken diese 'Störfelder' intensiv auf den Organismus ein. Eine Reduktion der technischen Feldeinflüsse erhöht daher die Schlafqualität und Regenerationskraft von Körper und Psyche. So gesehen gibt es einen standortbedingten Einfluß und auch einen durch Umweltbedingungen veränderlichen Einfluß an Schlafplätzen.

Die Menschen werden aufgeladen durch aufladbare Kleidungsstücke, Teppiche und Vorhänge. Zusätzlich erzeugt die übliche Art der Elektroinstallation störende Wechselfelder. Der Mensch, der viele Jahrtausende lang in der freien Natur bloßfüßig, daher naturgemäß erdegepolt, im natürlichen Wechselspiel des Spannungsfeldes gelebt hat, lebt heute in einem unnatürlichen 'Elektro-Klima'. Die Folgen sind Nervosität, Schlaflosigkeit und Krankheit; für Schädigungen des Immunsystems, Änderungen im Zellwachstum, grauer Star, Gedächtnisschwächen, Kreislauf- und Herzerkrankungen und vieles andere werden elektrische Störfelder verantwortlich gemacht. Auf einer Konferenz des 'American National Standard Institut' hat dieses Thema zu hitzigen Diskussionen geführt.

Unnatürliche Feldbedingungen setzen den - heute durch Hetze und Umweitgift ohnehin belasteten - Körper zusätzlich unter Streß - den Elektrostreß. Die zivilisatorischen Einrichtungen haben noch eine extreme Behinderung mit sich gebracht, deren weitläufige Auswirkungen bis heute noch nicht erschöpfend erforscht sind.

Bisherige Maßnahmen gegen nächtlichen Elektrostreß, z.B. der Einsatz von Netzfreischaltgeräten, ist in den meisten Schlafräumen nicht mehr ausreichend.

Auch im medizinischen Bereich, wie z.B. in Behandlungsräumen, Operationssälen und auch in den Krankenzimmern besteht der Bedarf der Abschirmung elektrischer und magnetischer Felder. Bei Operationssälen können durch den Einsatz von Vorrichtungen Messungen körpereigener Signale, wie z.B. EEG oder EKG, mit deutlich geringeren Störungen durchgeführt werden. Der Einsatz entsprechender Vorrichtungen in den Krankenzimmern ermöglicht sich unter anderem auch im Bereich der Liegestätten der Patienten. Durch den Einsatz solcher Vorrichtungen ist es möglich, die Genesung der Patienten entsprechend zu unterstützen und zu verbessern.

Der vorliegenden Erfindung liegt deshalb die Aufgabe zugrunde, ein Gewebe zu entwickeln, welches Silber in ausreichendem Maße beinhaltet, um elektrische und hochfrequente magnetische Felder abzuschirmen, wobei ein direkter Hautkontakt mit dem betreffenden Gewebe ermöglicht sein soll und bei der Fertigung des Gewebes eine Einsparung von Silbermaterial gegenüber den bisher bekannten Verfahren erzielt werden soll und daß das Gewebe einfach und problemlos zu verarbeiten ist, ohne den eingearbeiteten Silberanteil nachhaltig zu verändern.

Die Lösung der gestellten Aufgabe erfolgt durch die technische Lehre des kennzeichnenden Teils des Patentanspruchs 1.

Wichtig bei der Lösung dieser Aufgabe ist der Einsatz eines entsprechend behandelten Synthetik- oder Naturfasergarns, dessen Oberfläche vollkommen versilbert ist, wobei der Silberanteil mindestens 3% des Gesamtgarns beträgt. Dieses Spezialgewebe kann entweder gewoben oder gewirkt werden, wobei entweder die Kette oder der Schuß aus diesem Spezial-Silber-Garn besteht und der zweite Faden wahlweise aus einem anderen Gewebe bestehen kann.

Dieses so gefertigte Gewebe ist waschfest und kann problemlos verarbeitet werden. Vorzugsweise wird zur Erstellung des Spezial-Silber-Gewebes ein Polyamid-Faden verwendet, welcher eine variable Stärke aufweist, der eine dünne Silber-Metallisierung mit reinem Silber erfahren hat. Dieser Spezialfaden wird zu einem Spezial-Silber-Gewebe verarbeitet, welches wenigstens 22% Silber aufweist. Das Trägermaterial kommt durch die vollständige Versilberung nicht mehr zum Vorschein, und das Silber bleibt auch bei mechanischer Einwirkung während der Verarbeitung des Gewebes oder beim Waschen dauerhaft auf dem als Trägermaterial fungierenden Grundfaden.

Das Spezialgewebe besteht also aus einem Synthetik- oder Naturfasergarn, in welches entweder die Kette oder der Schuß mit dem Spezial-Silber-Garn gewoben oder gewirkt wird. Es wird ein Baumwollgewebe verwendet, bei dem der Silberanteil mindestens 3% vorzugsweise jedoch 22% des Gesamtgarnes beträgt.

Innerhalb der Liegefläche wird nun aus diesem Spezialstoff z.B. ein Spannleintuch hergestellt, welches mit einem Gummizugband auf einer Matratze oder einer Matratzenauflage befestigt wird. Mit einem Erdungsanschluß versehen werden die elektrischen Spannungen mittels eines Spezialerdungssteckers gegen Erde abgeleitet.

Je nach Anforderung kann das Stoffgewebe mehr oder weniger Silberfäden aufweisen. Ab einem Anteil von 22% vom Gesamtgewebe wird auch eine Abschirmwirkung gegen hochfrequente Strahlung von 100 Mhz bis 90 Ghz erreicht. Bei einem Gewebe, welches aus 100% Silberfäden hergestellt wird, kann eine Abschirmung von bis zu 40 db erfolgen. Dasselbe Gewebe bewirkt auch eine Reflexion bei Radarwellen (9,47 GHZ bis 12 Ghz) von 99%.

Der verwendete Silberfaden unterschiedlichster Stärke weist einen idealen Oberflächenwiderstand von bis zu 0,1 Ohm / inch² auf. Durch ein entsprechendes Webmuster entsteht auf der gesamten Stoffoberfläche eine an allen Meßpunkten stabile Leitfähigkeit bzw. ein gleichbleibender Oberflächenwiderstand. So können elektrische und statische Felder innert weniger Millisekunden von jedem Punkt des Spannleintuchs gegen Erde bei Körperkontakt auf Nullpotential geführt werden.

Nachdem der Bettbereich in der Regel mit Stoffhüllen und Stoffbezügen umgeben ist, sollte die Basis ein spezielles Stoffgewebe sein, welches einerseits die üblichen Stoffeigenschaften (Hygiene, Wärme, Feuchtigkeitsaufnahme, Waschbarkeit etc.) aufweist und andererseits auch in hohem Maße elektrisch leitfähig ist. Hier bieten sich Edelmetalle, insbesondere Silber an.

Silber weist im Vergleich zu den bisher verwendeten Materialien eine Reihe von zusätzlichen Vorteilen auf, welche noch zusätzlich erläutert werden können. So kann z.B. bei einem direkten Körperkontakt mit dem Spezialgewebe auch ein therapeutischer Effekt bei Hautekzemen und Hautallergien festgestellt werden. Das Spezialgewebe ist auch zur Herstellung von Allergiker-Bezügen geeignet, da durch den Silberanteil Mikroorganismen, wie z.B. Hausstaubmilben, keinerlei oder nur sehr erschwerte Lebensgrundlagen vorfinden.

Zusätzlich kann das Spezialgewebe auch zur Abschirmung von Bodenreizzonen (Gleichfeldstörungen) an Schlaf- und Arbeitsplätzen verwendet werden.

Das Spezialgewebe besteht aus einem Synthetik- und/oder Naturfasergarn, in welches entweder die Kette und/oder der Schuß mit dem Spezialgarn zu einem Stoff gewoben oder gewirkt wird. Vorzugsweise wird ein Baumwollgewebe verwendet, bei dem der Silberanteil mindestens 3% des Gesamtgarnes beträgt, was zu einer flächenhaften elektrischen Leitfähigkeit führt.

Der Anteil an Silberfäden im Verhältnis zum Gesamtgewebe ist variabel und wird je nach Verwendungszweck variiert. Entsprechende Web- und Wirkmuster aus dem Silberfaden garantieren eine flächenhafte elektrische Leitfähigkeit des Gesamtgewebes.

Vorzugsweise soll das Spezialgewebe zu Bettwäsche verarbeitet werden. Dabei ist an Spannleintücher gedacht, welche wie herkömmliche Spannleintücher auf der Matratze oder Matratzenauflage befestigt werden. Fußseitig befindet sich eine Vorrichtung für ein Erdungskabel, welches über eine Kupplung mit einem Erdungsstecker verbunden wird. Die Vorrichtung kann aus einem Druckknopf, einer Klemme, einem elektrisch leitfähigen Klettenband etc. bestehen.

Entscheidend ist, daß bei Verwendung als Spannleintuch der Schläfer direkten Kontakt zum Spezialgewebe hat und somit eine 100%-ige und kontinuierliche Ableitung der elektrischen und statischen Felder erfolgt.

Auch Bettbezüge für Zudecken sollen aus dem Spezialgewebe hergestellt werden. Bei einem entsprechend hohen Anteil von Silberfäden (mindestens 22%) kann dadurch der Körper vor hochfrequenten Strahlungen (Mikrowellen) geschützt werden. Die Erdung erfolgt über das darunter liegende Spannleintuch, welches bereits geerdet ist. Durch Berührungen der beiden Stoffflächen kommt es automatisch zu einer Erdung der Zudecke. Dasselbe gilt auch für Kissenbezüge.

Das Spezialgewebe kann aber auch direkt für die Herstellung von Bettwaren verwendet werden (als Matratzenbezug, als Hülle für Zudecken mit Füllungen etc.).

Das Spezialgewebe kann auch als Vorhang, Wandbehang oder ähnliches verwendet werden, wo dieselben Effekte erzielt werden.

Auch als Sitzbezug (z.B. für Autos, Flugzeuge) eignet sich das Material bei entsprechender Erdung zur Ableitung von elektrostatischen Aufladungen.

Des weiteren kann das Spezialgewebe Verwendung innerhalb von Kleidungsstücken zur Abschirmung unerwünschter Einstrahlungen auf den Körper erfolgen (z.b. bei Personen mit Herzschrittmachern oder für eine Tasche zur Befestigung von Handy's etc.).

Das Spezialgewebe kann auch zum Bespannen von Paravents zur Abschirmung unerwünschter Strahlungen verwendet werden. Die mit dem Spezialgewebe bespannten Paravents werden dann entsprechend dem Verlauf des Strahlungsfeldes aufgestellt (z.B. an Schlaf- und Arbeitsplätzen).

Das Gewebe eignet sich ebenfalls für jegliche Einsätze, wo Personen vorteilsweise unter geerdeten Bedingungen arbeiten sollten, wie z.B. bei Therapien, Operationen etc., dazu dienen Bezugsstoffe, Leintücher, Paravents, Vorhänge oder Bekleidung aus diesem Spezialgewebe.

Bei der Erfassung von Gehirnströmen und anderen durch Körper- und Körperfunktionen verursachten meßauswertbaren Signalen wird durch den Einsatz dieses Spezialgewebes ebenfalls eine deutlich verringerte Beeinflussung des Meßergebnisses durch Störgrößen erzielt.

Nachfolgend sei die vorliegende Erfindung anhand mehrerer verschiedener Ausführungsformen darstellende Figuren beschrieben.

Es zeigen:
- Figur 1:: ein Gewebe auf der Basis von silberbeschichteten Fäden,
- Figur 2:: eine Matratze mit Überzug aus silberbeschichtetem Spezialgewebe mit Erdungsanschluß,
- Figur 3:: eine Decke aus Spezialgewebe mit Silberbeschichtung,
- Figur 4:: ein Kissen aus Spezialgewebe mit Silberbeschichtung,
- Figur 5:: einen Paravent mit silberbeschichtetem Spezialgewebe,
- Figur 6:: einen Vorhang aus silberbeschichtetem Spezialgewebe,
- Figur 7:: einen Kfz.-Sitz mit einem Überzug aus silberbeschichtetem Spezialgewebe.

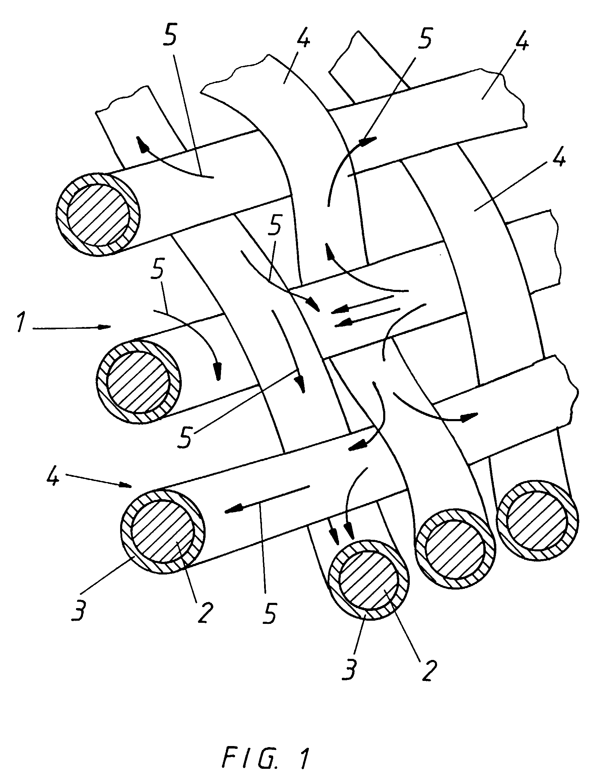

In Figur 1 ist in vergrößerter Darstellung ein Ausschnitt aus einem Gewebe gezeigt, welches aus mit Silber beschichteten Fäden hergestellt wurde. Das Spezialgewebe 1 besteht aus beschichteten Fäden 4, welche aus einem Trägermaterial 2 mit Silberbeschichtung 3 bestehen. In das Gewebe eingezeichnet sind mögliche Potentialflußlinien, die die Potentialabflußrichtung 5 darstellen, welche durch die Einwirkung von elektrischen oder magnetischen Feldern hervorgerufen werden. Durch die etwa hohlleiterförmige Ausbildung der Fäden ergibt sich ein Skin-Effekt auf den Oberflächen der Fäden, die durch die Silberbeschichtung physikalische Eigenschaften eines Hohlleiters aufweisen. Durch die Kontaktstellen der einzelnen Fäden miteinander herrscht ein dichtes, leitendes Gewebe vor, welches potentiale Unterschiede über die gesamte Fläche innerhalb kürzester Zeit ausgleicht und bei entsprechender Verbindung mit einem Erdanschluß das Potential gegen Erde ableitet.

Die im Gewebe eingezeichneten Pfeile stellen lediglich mögliche Potentialabflußrichtungen dar, welche bei Vorhandensein eines Erdungsanschlußes eine entsprechend ausgerichtete Abflußrichtung aufweisen. Durch das dichte Spezialgewebe 1 ergibt sich der Effekt, daß hochfrequente Strahlung im Bereich um das Gewebe durch die hohe Leitfähigkeit keinerlei Potentialunterschiede bewirkt. Dadurch werden die elektrischen und hochfrequenten magnetischen Felder in diesem Bereich neutralisiert, wodurch sich feldfreie Zonen ausbilden. Messungen haben ergeben, daß bei einer ausgelegten Fläche eines Spezialgewebes 1 in einem Abstand bis zu 50 cm keine elektrischen oder hochfrequenten magnetischen Feldlinien festzustellen sind, welche im Bereich niederfrequenter elektrischer Wechselfelder 50 Hz / 60 Hz und statischen Aufladungen liegen.

Durch das Ausbilden einer Fläche mit dem Spezialgewebe 1 ist es also möglich, einen dreidimensionalen Raum, der sich in etwa 50 cm über der Grundfläche des Spezialgewebes erstreckt, auszubilden, welcher frei von durch Hochfrequenz verursachte magnetische und elektrische Felder im Frequenzbereich von 100 Hz bis 90 Ghz ist.

Durch die Verwendung dieses Spezialgewebes 1 ergibt sich also der Vorteil, daß in dem oben beschriebenen dreidimensionalen Raum keine für den menschlichen Organismus schädigenden elektrischen oder magnetischen Felder nachweisbar sind. Unter Zugrundelegung dieser Erkenntnis kann durch Einsatz dieses Spezialgewebes 1 eine Ausbildung unterschiedlicher täglicher Bedarfsartikel in der Form von Matratzenbezügen, Leintüchern, Kissenbezügen, Deckenbezügen, Decken, Bezüge für Autositze sowie verarbeitungsfähigen Stoff erzeugt werden. Die Angabe dieser für den alltäglichen Gebrauch nutzbaren Gegenstände ist selbstverständlich nur beispielhaft und kann auf alle erdenklichen weiteren Gegenstände ausgeweitet werden.

Wichtig dabei ist, daß die Silberbeschichtung 3 des Trägermaterials 2 abriebfest über die gesamte Oberfläche des Trägermaterials 2 aufgebracht ist. Die Abriebfestigkeit ist dabei so hoch, daß das gefertigte Gewebe ohne besondere Maßnahmen verarbeitet werden kann und das Silber dauerhaft auf dem Trägermaterials 2 verbleibt, Im weiteren ist das Silbermaterial auch bei Waschvorgängen gegenüber Abrieb beständig und löst sich nicht vom Trägermaterial 2 ab. Dadurch ist es nun erstmals möglich, ein Gewebe zur Verfügung zu stellen, welches einen beliebig auswählbaren Prozentsatz an Silberanteil beinhaltet. Dadurch kann eine Optimierung zwischen Verbrauch und Wirkung des Silbers in einem zu einem Spezialgewebe verarbeiteten, mit Silber beschichteten Faden, erreicht werden.

Versuche haben ergeben, daß bei einem Anteil von 22% Silber im Gewebe die bereits oben beschriebene Wirkung einer Neutralisierung von elektrischen und magnetischen Feldern, welche auf hochfrequenter Strahlung basieren, erzielt wird. Dadurch besteht der enorme Vorteil, daß die Kosten für das zu verarbeitende Silber enorm reduziert werden können und gleichzeitig eine maximale Wirkung des erstellten Spezialgewebes 1 sichergestellt ist.

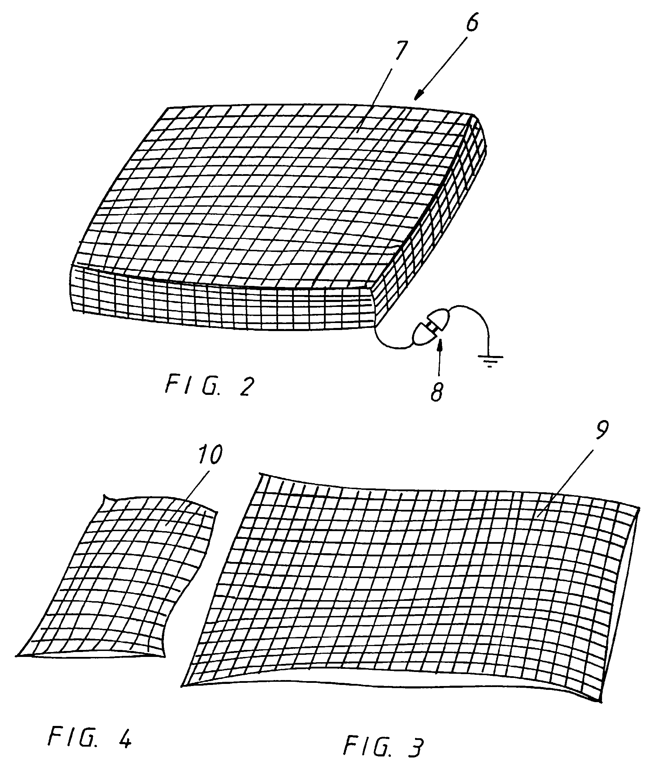

In Figur 2 ist eine Matratze dargestellt, deren Bezugsstoff aus dem oben genannten Spezialgewebe 1 gefertigt ist. Ein an einer entsprechenden Stelle angeordneter Stecker dient zur leitenden Verbindung mit einem Erdanschluß. Durch die Ausbildung des Bezugsstoffes 7 der Matratze 6 als leitendes Gewebe kann durch die Steckverbindung 8 ein entsprechend auftretender Potentialunterschied gegenüber der Erde abgeleitet werden. Durch die Ausbildung der Matratze 6 mit dem Bezugsstoff 7, welcher aus dem Spezialgewebe 1 gefertigt wurde, ergibt sich oberhalb der Matratze bis zum Abstand von ungefähr 60 cm ein nachweisbar feldfreier Raum, welcher elektrische oder magnetische Felder auf der Grundlage von hochfrequenten Strahlungen ausbilden. Dadurch entsteht für die darauf liegende Person der bereits eingangs der Beschreibung dargelegte Vorteil, welcher feldfreie Räume für den menschlichen Organismus bewirken.

In Figur 3 und 4 sind ein Deckenüberzug und ein Kissenbezug dargestellt, welche auf der Grundlage des Spezialgewebes 1 gefertigt wurden. Der Deckenbezug 9 stellt eine elektrisch leitende Verbindung zu einem darunter befindlichen, ebenfalls aus einem Spezialgewebe 1 hergestellten, Leintuch her, welches seinerseits eine Verbindung zum Bezugsstoff 7 der Matratze 6 und damit zum Anschluß an die Erdung bewirkt. Dasselbe gilt für den Kissenbezug 10, welcher dieselben elektrischen Leitfähigkeiten aufweist, wie der Deckenbezug 9.

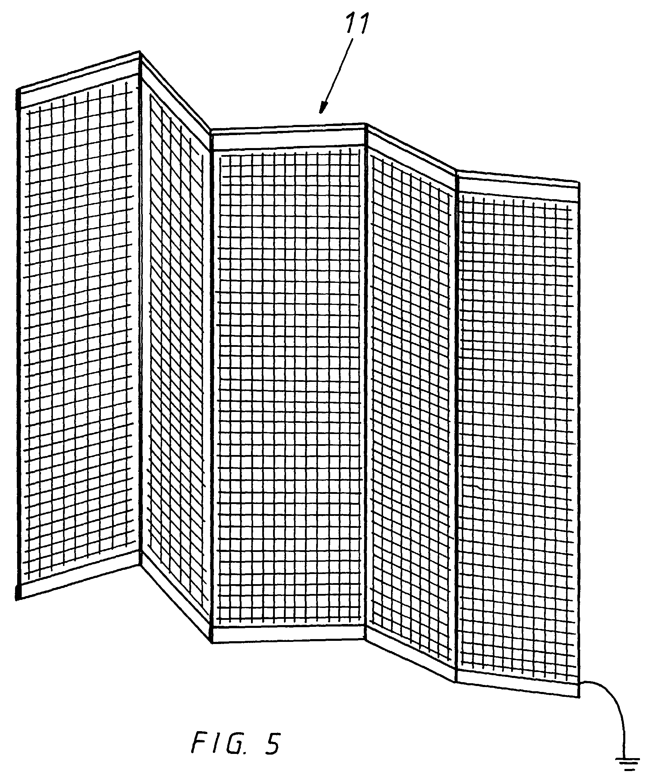

In Figur 5 ist ein Paravent 11 dargestellt, welcher auf die Flächen aufgespanntes Spezialgewebe 1 aufweist, das die physikalische Eigenschaft beherbergt, bis zu einem Abstand von etwa 60 cm einen feldfreien, dreidimensionalen Raum auszubilden. Dadurch ist es möglich, z.b. in Behandlungszimmern im Bereich von Meßgeräten einen feldfreien Raum auszubilden und dadurch das Meßergebnis abfälschende Einflüsse durch hochfrequente Strahlung abzuschwächen oder vollkommen fern zu halten. Dies ist im besonderen bei EEG- bzw. EKG-Messungen von Vorteil, da es sich hier um geringe Körperströme handelt, die durch empfindliche Meßgeräte ausgewertet werden.

Ein weiterer denkbarer Einsatzbereich von Paravents, welche mit dem Spezialgewebe 1 überzogen sind, sind z.B. Arbeitsbereiche, in denen relativ starke Strahlung freigesetzt wird. Paravents können in diesem Fall so aufgestellt werden, daß sie die Ausbreitung der Strahlung auf ein Minumum reduzieren. Dadurch werden umliegende Bereiche in Büros vor unnötiger Strahlenbelastung geschützt.

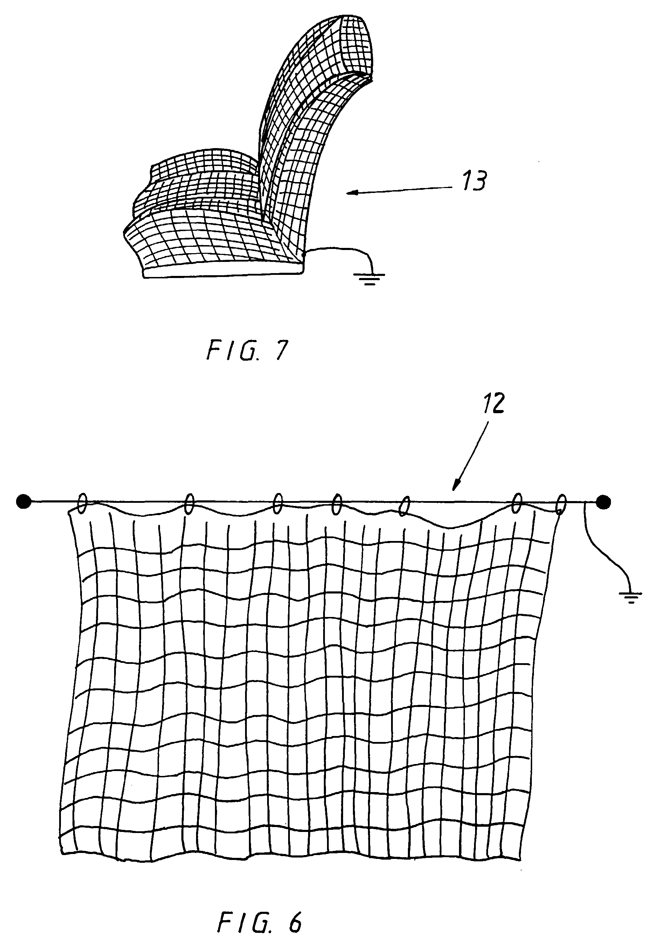

Eine weitere Möglichkeit der Anwendung des Spezialgewebes 1 zeigt die Figur 6, welche einen Vorhang aus Spezialgewebe 1 zeigt. Durch den Einsatz eines solchen Vorhangs ist es möglich, hochfrequente Strahlung vor dem Eindringen durch das Fenster in den betroffenen Raum abzuschirmen. Auch hier ist es möglich, einen entsprechenden Anschluß anzubringen, welcher eine Ableitung des Potentials gegen Erde ermöglicht.

In Figur 7 ist ein Beispiel eines Sitzbezugs 13 dargestellt, welcher in diesem Fall auf einem Kfz.-Sitz angeordnet ist. Auch hier ist die Möglichkeit einer Verbindung des Sitzbezuges mit der Karosserie gegeben. Auch in diesem Fall ergibt sich ein .dreidimensionaler Raum um die Kontur des Sitzbezugs herum, welche die bereits beschriebenen Auswirkungen auf den menschlichen Körper haben.

Zusammenfassend wir darauf hingewiesen, daß durch die Ausbildung eines Spezialgewebes 1 nun die Möglichkeit besteht, entsprechende für den alltäglichen Gebrauch brauchbare Artikel herzustellen, welcher der Gesundheit des Benutzers in der eingangs beschriebenen Art und Weise zuträglich sind.

### Zeichnungs-Legende

- 1: Spezialgewebe
- 2: Trägermaterial
- 3: Silberbeschichtung
- 4: beschichteter Faden
- 5: Potentialabflußrichtung
- 6: Matratze
- 7: Bezugsstoff
- 8: Steckverbindung
- 9: Deckenbezug
- 10: Kissenbezug
- 11: Paravent
- 12: Vorhang
- 13: Sitzbezug

## Patentansprüche

1. Gewebe mit Silberanteil, bestehend aus gewebten, gewirkten oder sonstig verarbeiteten Grundmaterialien, die zur Herstellung von Gewebe geeignet sind, **dadurch gekennzeichnet**, daß wenigstens ein als Grundmaterial dienender, mit Silberbeschichtung (3) beschichteter, Faden (4) im Gewebe eingearbeitet ist.

2. Gewebe nach Anspruch 1, **dadurch gekennzeichnet**, daß der mit Silberbeschichtung (3) beschichtete Faden (4) die Kontur und damit die physikalische Eigenschaft eines Hohlleiters aufweist.

3. Gewebe nach einem der Ansprüche 1 oder 2, **dadurch gekennzeichnet**, daß durch das Einarbeiten eines beschichteten Fadens (4) in das Spezialgewebe (1) als Hohlleiter ausgebildete Fäden das Gewebe durchziehen.

4. Gewebe nach einem der Ansprüche 1 bis 3, **dadurch gekennzeichnet**, daß die als Hohlleiter ausgebildeten beschichteten Fäden (4) sich wenigstens teilweise berühren.

5. Gewebe nach einem der Ansprüche 1 bis 4, **dadurch gekennzeichnet**, daß die Oberfläche des Spezialgewebes (1) eine potentialunterschiedsfreie Fläche ausbildet.

6. Gewebe nach Anspruch 5, **dadurch gekennzeichnet**, daß sich von beiden Seiten der Oberfläche des Spezialgewebes (1) ab, gemessen bis zu einer Entfernung von etwa 60 cm, jeweils ein potentialunterschiedsfreier, dreidimensionaler Raum ausbildet.

7. Gewebe nach einem der Ansprüche 1 bis 6, **dadurch gekennzeichnet**, daß das Spezialgewebe (1) unter herkömmlichen Verarbeitungsmethoden, wie Zuschneiden, Heften und Vernähen, abriebfrei verarbeitbar ist.

8. Gewebe nach einem der Ansprüche 1 bis 7, **dadurch gekennzeichnet**, daß das Spezialgewebe (1) waschbar ist, ohne daß der Silberanteil wesentlich beeinflusst wird.

9. Gewebe nach einem der Ansprüche 1 bis 8, **dadurch gekennzeichnet**, daß das Spezialgewebe (1) mit unterschiedlichen Maschenweiten gefertigt wird, so daß daraus Produkte für verschiedene Lebensbereiche hergestellt werden können, deren Dichte dem entsprechenden Einsatzbereich entsprechen, wie Bezugsstoffe, Leintücher, Paravents, Vorhänge oder Bekleidung.

10. Gewebe nach einem der Ansprüche 1 bis 9, **dadurch gekennzeichnet**, daß das aus dem Spezialgewebe (1) gefertigte Produkt mit einem elektrisch leitenden Anschluß versehen ist.

11. Gewebe nach einem der Ansprüche 1 bis 10, **dadurch gekennzeichnet**, daß das Spezialgewebe wenigstens 22% Silber aufweist.

12. Gewebe nach einem der Ansprüche 1 bis 11, **dadurch gekennzeichnet**, daß der Silberanteil mindestens 3% des Gesamtgarns beträgt.
